# EUROPEAN PATENT APPLICATION

(11) **EP 4 202 550 A1**
(43) Date of publication of application: **28.06.2023**
(21) Application number: 21216952.8
(22) Date of filing: 22.12.2021
(51) Int. Cl.: G03F 7/20, G03F 1/44

(54) **SUBSTRATE COMPRISING A TARGET ARRANGEMENT, ASSOCIATED PATTERNING DEVICE, LITHOGRAPHIC METHOD AND METROLOGY METHOD**

(71) Applicant: ASML Netherlands B.V., 5500 AH Veldhoven (NL)
(72) Inventor: CRAMER, Hugo Augustinus Joseph, 5500 AH Veldhoven (NL); VAN DEN BOS, Karel Hendrik Wouter, 5500 AH Veldhoven (NL); GARCIA GRANDA, Miguel, 5500 AH Veldhoven (NL); VAN DER SCHAAR, Maurits, 5500 AH Veldhoven (NL); OP 'T ROOT, Wilhelmus Patrick Elisabeth Maria, 5500 AH Veldhoven (NL)
(74) Representative: ASML Netherlands B.V.

(57) **Abstract**

Disclosed is a method of measuring a focus parameter from a focus target, and associated substrate and associated patterning device. The focus target comprises at least a first sub-target and a second sub-target, each having at least a periodic main feature, wherein a respective pitch and/or dimensional parameter of at least some sub-elements of the main feature are configured such that said first sub-target and second sub-target have a respective different best focus value; and wherein each said main feature is formed with a focus dependent center-of-mass and/or pitch. The method comprises obtaining a first measurement signal from said first sub-target and a second measurement signal from said second sub-target; determining a difference signal of said first measurement signal and second measurement signal; and determining said focus parameter from said difference signal.

## Description

### BACKGROUND

### Field of the Invention

The present invention relates to a target arrangement for metrology of a lithographic process and to a method to measure a parameter of a lithographic process.

### Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., 40µm by 40µm, gratings and the measurement beam generates a spot that is smaller than the grating (i.e., the grating is underfilled). This simplifies mathematical reconstruction of the target as it can be regarded as infinite. However, in order to reduce the size of the targets, e.g., to 10µm by 10µm or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

One important parameter of a lithographic process which requires monitoring is focus. There is a desire to integrate an ever-increasing number of electronic components in an IC. To realize this, it is necessary to decrease the size of the components and therefore to increase the resolution of the projection system, so that increasingly smaller details, or line widths, can be projected on a target portion of the substrate. As the critical dimension (CD) in lithography shrinks, consistency of focus, both across a substrate and between substrates, becomes increasingly important. CD is the dimension of a feature or features (such as the gate width of a transistor) for which variations will cause undesirable variation in physical properties of the feature.

Traditionally, optimal settings were determined by "send-ahead wafers" i.e. substrates that are exposed, developed and measured in advance of a production run. In the send-ahead wafers, test structures were exposed in a so-called focus-energy matrix (FEM) and the best focus and energy (exposure dose) settings were determined from examination of those test structures. More recently, focus metrology targets are included in the production designs, to allow continuous monitoring of focus performance. These metrology targets should permit rapid measurements of focus, to allow fast performance measurement in high-volume manufacturing. Ideally, the metrology targets should be small enough that they can be placed among the product features without undue loss of space.

Current test structure designs and focus measuring methods have a number of drawbacks. Known focus metrology targets require sub-resolution features and/or grating structures with large pitches. Such structures may contravene design rules of the users of lithographic apparatuses. Asymmetry in a grating structure can be measured effectively using high-speed inspection apparatus such as a scatterometer, working at visible radiation wavelengths. Known focus measuring techniques exploit the fact that focus-sensitive asymmetry can be introduced into structures printed in a resist layer by special design of the patterns on a patterning device that defines the target structure. For EUV lithography, where printing is performed using radiation of a wavelength less than 20 nm, for example 13.5 nm, the creation of sub-resolution features becomes even more difficult. For EUV lithography, resist thickness, and therefore the thickness of target structures, is smaller. This weakens the diffraction efficiency, and hence the signal strength, available for focus metrology.

For these reasons, there is a need to develop new techniques for the measurement of focus performance in lithographic processes, particularly in EUV lithography, but also for projectionbased lithography in general.

### SUMMARY OF THE INVENTION

It would be desirable to be able to perform metrology of a lithographic process with increased accuracy.

The invention in a first aspect provides a method of measuring a focus parameter from a focus target, the focus target comprising at least one self-referenced pair of sub-targets, the self-referenced pair of sub-targets comprising a first sub-target and a second sub-target, wherein each of said first sub-target and second sub-target comprises at least a periodic main feature; wherein a respective pitch and/or dimensional parameter of at least some sub-elements of the main feature are configured such that said first sub-target and second sub-target have a respective different best focus value; and wherein each said main feature is formed with a focus dependent center-of-mass and/or pitch; the method comprising: obtaining a first measurement signal from said first sub-target and a second measurement signal from said second sub-target; determining a difference signal of said first measurement signal and second measurement signal; and determining said focus parameter from said difference signal.

The invention in a second aspect provides a substrate comprising at least one focus target for measuring a focus parameter, the focus target comprising at least one self-referenced pair of sub-targets, the self-referenced pair of sub-targets comprising a first sub-target and a second sub-target, wherein each of said first sub-target and second sub-target comprises at least a periodic main feature; wherein a respective pitch and/or dimensional parameter of at least some sub-elements of the main feature are configured such that said first sub-target and second sub-target have a respective different best focus value; and wherein each said main feature is formed with a focus dependent center-of-mass and/or pitch.

The invention in a third aspect provides a substrate comprising at least one focus target or sub-target thereof comprising at least a periodic main feature having a main feature pitch, wherein a center-of-mass and/or main feature pitch is focus dependent; and a periodic reference feature having a reference feature pitch different from said main feature pitch, the main feature and reference feature being arranged such that scattered radiation from the main feature and the reference feature interfere to form a beat signal or Moire signal.

The invention in a fourth aspect provides a method of measuring a focus parameter from a focus target on a substrate as off the third aspect, comprising: imaging Moire fringes resulting from interference between at least one diffraction order from the main feature and at least one corresponding diffraction order from the reference feature to obtain a measurement signal; and determining said focus parameter from said measurement signal.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying drawings in which:
Figure 1 depicts a lithographic apparatus according to an embodiment of the invention;
Figure 2 depicts a lithographic cell or cluster according to an embodiment of the invention;
Figure 3 comprises (a) a schematic diagram of a dark field scatterometer for use in measuring targets using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
Figure 4 depicts a known form of multiple grating target and an outline of a measurement spot on a substrate;
Figure 5 depicts an image of the target of Figure 4 obtained in the scatterometer of Figure 3;
Figure 6 is an illustration of (a) a first example of a focus target according to an embodiment, (b) the resultant printed target for different focus levels, (c) plots of measured center-of-mass against focus for the two sub-targets of the target of Figure 6(a) and (d) a plot of the difference of measured center-of-mass from the plots of Figure 6(c) against focus;
Figure 7 is an illustration of a second example of a focus target according to an embodiment;
Figure 8 is an illustration of a third example of a focus target according to an embodiment
Figure 9 is an illustration of a fourth example of a focus target according to an embodiment;
Figure 10 is an illustration of a first Moire example of a focus target according to an embodiment;
Figure 11 is an illustration of a second Moire example of a focus target according to an embodiment;
Figure 12 is an illustration of a third Moire example of a focus target according to an embodiment; and
Figure 13 is an example of an imaged Moire pattern obtained when measuring any of the target examples illustrated in Figures 10 to 12.

### DETAILED DESCRIPTION OF EXEMPLARY EMBODIMENTS

Before describing embodiments of the invention in detail, it is instructive to present an example environment in which embodiments of the present invention may be implemented.

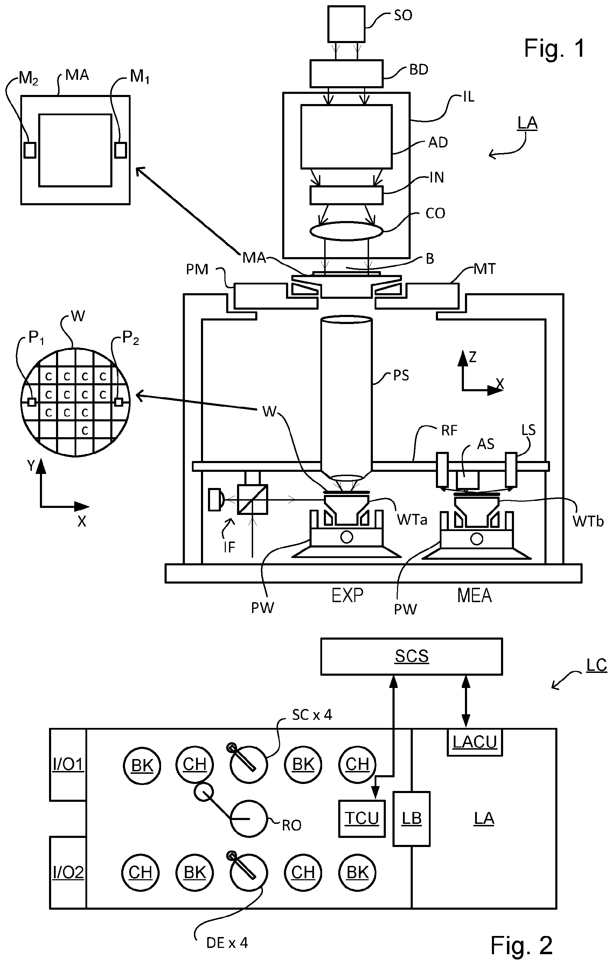

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

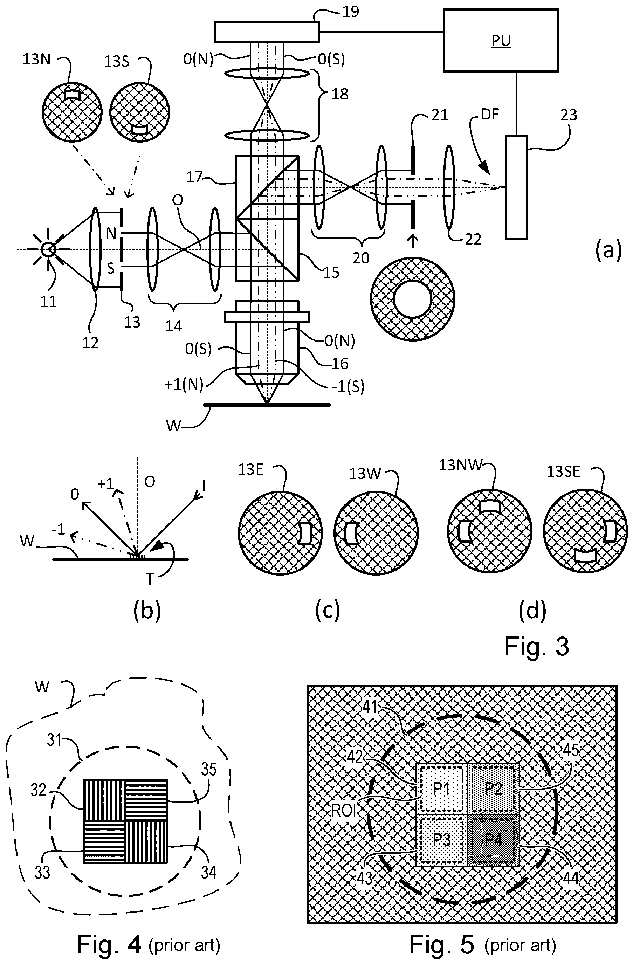

A metrology apparatus is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatialfrequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a backprojected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 3(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2^{nd}, 3^{rd} and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d) . The use of these, and numerous other variations and applications of the apparatus are described in prior published applications, mentioned above.

Figure 4 depicts an overlay target or composite overlay target formed on a substrate according to known practice. The overlay target in this example comprises four sub-targets (e.g., gratings) 32 to 35 positioned closely together so that they will all be within a measurement spot 31 formed by the metrology radiation illumination beam of the metrology apparatus. The four sub-overlay targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of an overlay target. An overlay target may comprise more or fewer than 4 sub-targets.

Figure 5 shows an example of an image that may be formed on and detected by the sensor 23, using the overlay target of Figure 4 in the apparatus of Figure 3, using the aperture plates 13NW or 13SE from Figure 3(d). While the pupil plane image sensor 19 cannot resolve the different individual sub-targets 32 to 35, the image sensor 23 can do so. The hatched area 40 represents the field of the image on the sensor, within which the illuminated spot 31 on the substrate is imaged into a corresponding circular area 41. Within this, rectangular areas 42-45 represent the images of the small overlay target sub-targets 32 to 35. If the overlay targets are located in product areas, product features may also be visible in the periphery of this image field. Image processor and controller PU processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay targets have been identified, the intensities of those individual images can be measured, e.g., by averaging or summing selected pixel intensity values within the identified areas. Intensities and/or other properties of the images can be compared with one another. These results can be combined to measure different parameters of the lithographic process.

In the following disclosure, techniques will be illustrated for measuring focus performance of a lithographic process that uses oblique illumination on a reflective type of patterning device. These techniques may be applied in particular in EUV lithography, where reflective optics in a near-vacuum environment are required. Metrology targets including certain focus metrology patterns will be printed on the substrate, at the same time as product features are printed. Asymmetry in these printed patterns will be measured using for example diffraction based techniques in the apparatus of Figure 3. To allow the use of small targets, it will be assumed that these asymmetry measurements will be performed using the dark-field imaging branch of the apparatus. Diffraction-based measurements of asymmetry can also be made using the pupil imaging branch, however. Of course, the apparatus shown in Figure 3 is only one example of an inspection apparatus and method that may be used to measure asymmetry.

In the context of lithographic apparatuses working in the DUV wavelength range, targets for diffraction-based focus (DBF) measurements have been designed and used successfully. A known type of DBF target is produced by including sub-segmented features in a grating pattern on the reticle. These features have dimensions below the imaging resolution of the lithographic apparatus, alongside more solid features. Consequently, they do not print as individual features in the resist layer on the substrate, but they influence the printing of the solid features, in a manner that is sensitive to focus error. Specifically, the presence of these features creates an asymmetric resist profile for each line in the grating within the DBF metrology target, with the degree of asymmetry being dependent upon focus. Consequently a metrology tool such as the inspection apparatus of Figure 3 can measure the degree of asymmetry from a target formed on the substrate, and translate this into the scanner focus.

Unfortunately, the known DBF metrology target designs are not suitable for use in all situations. In EUV lithography, resist film thicknesses are significantly lower than those used in DUV immersion lithography, leading to low diffraction efficiency and difficulty extracting accurate asymmetry information from diffracted radiation in the scatterometer. In addition, since the resolution of the imaging system is inherently higher in EUV lithography, features having dimensions below the printing resolution of DUV immersion lithography become "solid" features printable by EUV lithography. To provide analogous sub-resolution features on an EUV reticle is rather impractical, and/or may violate semiconductor manufacturer's "design rules". Such rules are generally established as a means to restrict the feature designs to ensure the printed features conform to their process requirements. In any case, working outside the design rules makes it difficult to simulate the performance of the process on the DBF targets, so that the optimum target design and the calibration of focus measurements becomes a matter of trial-and-error. The desire to conform to design rules applies to DBF targets in DUV lithography, not only EUV lithography.

As such, methods and target designs for obtaining a stronger and/or more robust signal from a focus target using a scatterometer are desirable. To achieve this a focus target for measuring a focus parameter relating to the focus target is disclosed, comprising at least one self-referenced pair of sub-targets, the self-referenced pair of sub-targets comprising a first sub-target and a second sub-target, wherein each of said first sub-target and second sub-target comprises at least a periodic main feature; wherein a respective pitch and/or dimensional parameter (e.g., critical dimension CD) of at least some sub-elements of the main feature are configured such that said first sub-target and second sub-target have a respective different best focus value; and wherein each said main feature is formed with a focus dependent center-of-mass and/or pitch measureable using a scatterometer.

A focus parameter can be determined from measuring the focus target with a scatterometer, the focus parameter relating to a focus setting of a lithographic exposure process on which said target was exposed. Also disclosed is a substrate comprising at least one such target and a reticle or mask comprising target forming features for forming at least one such target.

As such, also disclosed is a method of measuring a focus parameter, from a focus target comprising at least a first sub-target and a second sub-target, each having at least a periodic main feature, wherein a respective pitch and/or dimensional parameter of at least some sub-elements of the main feature are configured such that said first sub-target and second sub-target have a respective different best focus value; and wherein each said main feature is formed with a focus dependent center-of-mass and/or pitch; the method comprising: obtaining a first measurement signal from said first sub-target and a second measurement signal from said second sub-target; determining a difference signal of said first measurement signal and second measurement signal; and determining said focus parameter from said difference signal substrate and associated patterning device.

The "center-of mass" of each sub-target or structure may comprise the peak position of the first harmonic of the pattern defined by the printed structure.

To obtain a stronger signal when measuring the center-or-mass of the targets, it is proposed that the focus target may be configured for a self-referenced phase measurement of the center-of-mass of the sub-targets using a scatterometer. This is particularly useful for EUV applications with thin resists, as purely intensity based (or intensity asymmetry based) focus metrology techniques suffer from very low signal strength and unreliable inference (poor repro) when measuring known focus targets in such thin resists. Self-referenced in this context means that the detected fringe position (phase measurement) indicative of center-of-mass or pitch from a first sub-target is compared to the fringe position of the second sub-target.

By way of a first such example, to obtain a fringe pattern indicative of center-of-mass or pitch, each sub-target may be configured such that the scatterometer can capture first and second diffraction orders and measure a center-of-mass/pitch and therefore focus dependent phase therefrom. These orders will interfere to provide a fringe pattern on the scatterometer's detector (camera), which will shift in position with focus. By measuring the difference in fringe position, and therefore the difference in center-of-mass, for each sub-target, a monotonic relationship of measurement signal with focus is obtained.

Alternatively, each sub-target may comprise a periodic reference feature having a different pitch to the periodic main feature, such that scattered radiation from the focus dependent main feature and the reference feature interfere to form a beat signal or Moire signal. This Moire signal can then be imaged using the scatterometer, with the difference in Moire fringe position for the two sub-targets measured to determine a difference in center-of-mass for each sub-target indicative of focus.

In an embodiment, the pitches of the main feature Pₘₐᵢₙ and reference feature P_{ref} have a small difference (e.g., a difference of less than 20% or 10% of the pitch of the main feature). This creates two 1st order diffracted beams with a slightly different direction. Upon recombination in the image a Moire beat pattern becomes visible with a pitch 1/P_{beat}=1/P_{ref}-1/Pₘₐᵢₙ. As such, the Moire effect amplifies the phase shift; e.g., a 10% pitch difference provides up to a 10x amplification of the shift.

The main feature of each of the sub-targets may comprise a periodic (e.g., ID or 2D) array of main feature elements, where each main feature element comprises a larger first sub-element and multiple smaller second sub-elements. The second sub-elements may comprise features having a CD and/or pitch at or close to product dimensions, and as such may be referred to as at-resolution sub-elements. For example, the second sub-elements may comprise a ID array of such at-resolution second sub-elements, either parallel or perpendicular to the (longest dimension of the) first sub-element. The first sub-element may be a solid element, or else it may be a periodic element (e.g., having a CD and/or pitch at or close to product dimensions).

The main pitch of main feature may be sufficiently large to be compatible with (measurable by) a scatterometer apparatus (e.g., such as illustrated in Figure 3(a)). As such, this main pitch should provide at least a detectable first order. For example, this main pitch Pₘₐᵢₙ may meet the criterion: 0.7< *λ*/Pₘₐᵢₙ>1.3, where *λ* is the radiation wavelength of the measurement radiation. In the embodiment where the sub-targets have no reference feature, this main pitch should provide a detectable first and second order.

To impose the different best focus for each sub-target, it is proposed that the CD and/or pitch of the at-resolution features may differ between the sub-targets. This may be the CD and/or pitch of the second sub-elements and/or, where the first sub-element is a periodic element, the CD and/or pitch of the first sub-element. Best focus may indicate a focus setting for which CD variation is minimal over a small range (e.g., +/- 5nm) around the best focus and/or a focus setting at the peak or trough of a corresponding Bossung curve for that sub-target; i.e., where CD sensitivity for small focus changes is lowest.

The pitch and/or CD of these at-resolution features may be optimized in a computational lithography step (e.g., using source-mask optimization SMO) to obtain a sufficient and/or to maximize the best focus difference between the sub-targets. Also, additional techniques, such as altering the absorber on the mask between the two sub-targets, may be employed to further maximize the best focus offset; e.g., by forming one (or both) targets on the mask using a different mask absorber than the standard Ta-based absorber (e.g., low-n absorbers with refractive index n<0.92 and other EUV absorbers).

In the reference feature embodiments, the reference feature may be comprised in another layer of the device, and/or may be interlaced with the main feature. In a specific example, the reference feature may be interlaced in a direction perpendicular to the periodicity of the main feature. In such an embodiment, the perpendicular pitch of the main feature in this perpendicular direction P_{PP} may be sufficiently small to be unresolved. For example this perpendicular pitch P_{PP} may meet the criterion *λ*/P_{PP}>1.2, where *λ* is the radiation wavelength of the measurement radiation.

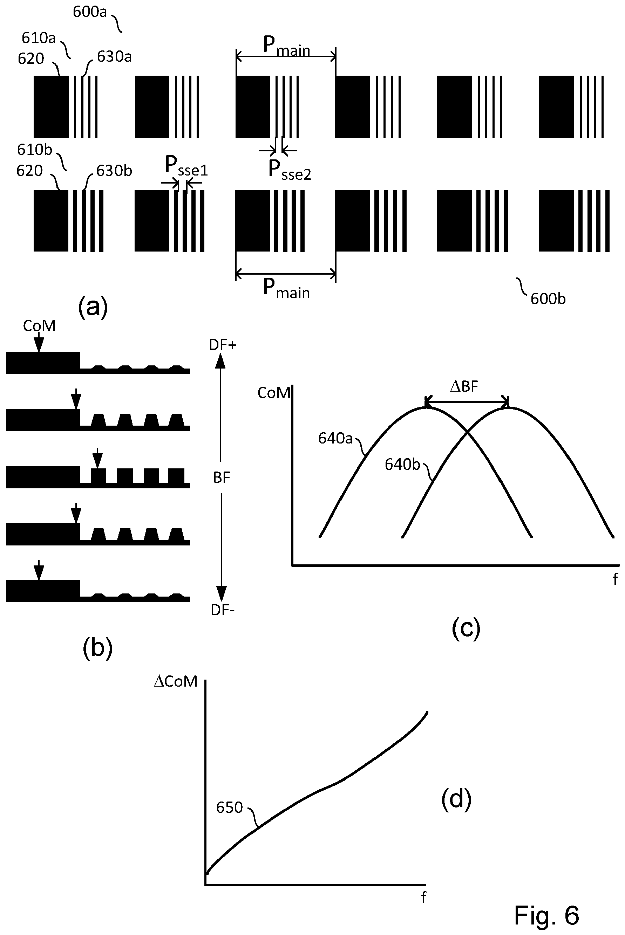

Figure 6 is a drawing illustrating how the proposed method and focus target may be used to monitor focus. Figure 6(a) shows a first embodiment of a focus target or main feature thereof, comprising a first sub-target 600a and second sub-target 600b. Each sub-target 600a, 600b comprises respective main feature elements 610a, 610b, each respective main feature element 610a, 610b comprising a first sub-element 620 (in this example a solid block) and respective second sub-elements 630a, 630b. As will be described, each sub-target may also comprise reference features (not shown in this drawing), either interlaced in the same layer, quasi interlaced (interlaced in a direction perpendicular to the main pitch periodicity of the main feature) in the same layer or in a different layer (e.g., a reference layer).

A main pitch Pₘₐᵢₙ of the target should be compatible with the scatterometer used to measure the target, so as to generate at least detectable first diffraction orders. Where reference features are provided, it is sufficient that only detectable first orders are generated to enable performance of a phase measurement. If the target does not have reference features then the main pitch Pₘₐᵢₙ should be configured to generate at least detectable first and second orders to enable performance of a phase measurement.

As has been described, each of the sub-targets 600a, 600b have a different best focus setting. This is achieved through Mask3D effects, i.e., the effect resultant from non-normal illumination on a reflective mask comprising 3D patterning features. In particular, and more specifically the pitch and/or CD of the second sub-elements 630a may be different to the second sub-elements 630b to exploit this Mask3D effect. In the specific example shown, the pitch Pₛₛₑ₁ of the second sub-elements 630a is different to the pitch Pₛₛₑ₂ of the second sub-elements 630b. Furthermore, the CD of the second sub-elements 630a is different to the CD of the second sub-elements 630b. However, only one of pitch and CD need be varied.

Figure 6(b) illustrates how each printed main feature element 610a, 610b varies with the focus setting of the lithographic apparatus used to image the main feature element. The target shown in Figure 6(a) is the target as formed on the mask (and approximately as printed at best focus). Figure 6(b) shows a printed main feature element 610a, 610b, in cross-section, corresponding to the target of Figure 6(a) for five different focus settings. The center image shows the main feature element printed at best focus BF, above this are two images of the printed main feature element at two corresponding higher magnitude positive defocus DF+ values, and below the best focus BF image are two images of the printed main feature element at two corresponding higher magnitude negative defocus DF- values. In each case, an arrow is shown which indicates the printed feature's center-of-mass.

Figure 6(c) comprise plots 640a, 640b of the measured center-of-mass CoM of respectively the first sub-target and second sub-target against focus f. Each of these plots comprise Bossung curves, as is well known in focus monitoring. Also shown is an indication of the difference of the best focus positions ΔBF of the two sub-targets. Figure 6(d) shows an equivalent plot of ΔCoM against focus, where ΔCoM is the difference of the CoM values for the plots 640a, 640b. As can be seen, this difference ΔCoM has a monotonic relationship with focus. The slope and therefore sensitivity of ΔCoM with focus may be increased by increasing the difference of the best focus positions ΔBF.

As stated, the center-of-mass may be inferred from the difference in position (translation) from each sub-target of imaged fringes of interference of the first and second diffraction orders, or from Moire fringes where the target comprises reference features. Other methods include inferring the center-of-mass from an intensity difference of the two sub-targets.

The method may comprise an initial calibration stage, e.g., to calibrate the relationship of the center-of-mass difference ΔCoM with focus (the relationship illustrated in Figure 6(d)). This may comprise printing an array of calibration focus targets (i.e., being the same as the focus targets to be used in the manufacturing phase) at different known focus settings (or different focus/dose settings), measuring the center-of-mass difference ΔCoM from the calibration focus targets and determining the relationship of this center-of-mass difference ΔCoM with the known focus settings.

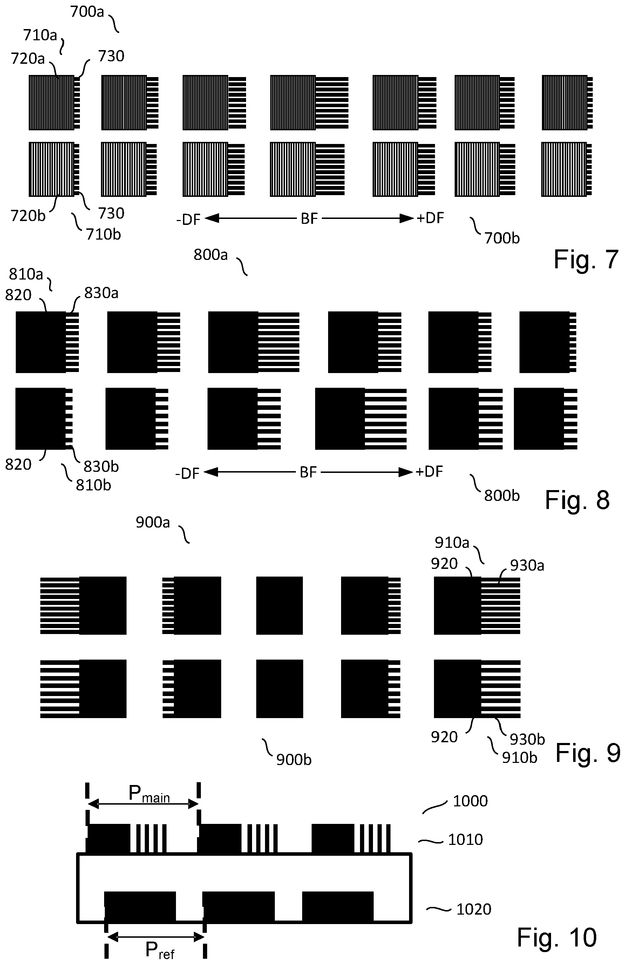

Figures 7-9 illustrate a number of example target designs, which may be used as an alternative to the embodiment of Figure 6(a). Each of these target designs may be combined with a reference feature, either interlaced in the same layer, quasi-interlaced in the same layer or in a different layer (e.g., reference layer), to generate a Moire signal, as will be described. In each case (as with the example of Figure 6(a), the target may vary in detail from those shown, and for example may comprise a different number of main feature elements, different dimensions, pitches or number of individual elements shown.

Figure 7 shows a second embodiment of a target (or main feature thereof), comprising a first sub-target 700a and second sub-target 700b. Each sub-target 700a, 700b comprises respective main feature elements 710a, 710b, each respective main feature element 710a, 710b comprising a respective first sub-elements 720a, 720b and second sub-elements 730. The main sub-element 720a, 720b in this example are gratings, the grating of first sub-element 720a having a different pitch and/or CD (pitch in the drawing shown) as the grating of first sub-element 720b. This provides the different best focus of the two sub-targets. In this example, the second sub-elements 730, which provide the focus dependent center-of-mass, are perpendicular to the first sub-elements, and extend from the side of the first sub-elements as fingers. In this example, the second sub-elements 730 have the same dimensions for the two sub-targets 710a, 710b. However, they may also differ in terms of pitch and/or CD for the two sub-targets 710a, 710b, either as an alternative or in addition to the respective pitch/CD of the gratings of the first sub-elements.

Note that this Figure is not shown as a complete sub-target as it would be printed normally, but is represented here with individual feature elements printed at different focus settings (purely for illustration), with an approximate best focus BF (noting that each sub-target has a different best focus) in the center and moving away to greater defocus in each direction along the arrows. Each feature element may comprise the same width/center-of-mass on the mask, and (for a single focus setting) the actual target as printed would also comprise feature elements having substantially/approximately uniform center-of-mass which is dependent on that focus setting.

Figure 8 shows a third embodiment of a target (or main feature thereof), comprising a first sub-target 800a and second sub-target 800b. Each sub-target 800a, 800b comprises respective main feature elements 810a, 810b, each respective main feature element 810a, 810b comprising a respective first sub-element 820 and second sub-elements 830a, 830b. The main sub-element 820 in this example comprises a sold block. In this example, the second sub-elements 830a, 830b, which provide the focus dependent center-of-mass, are again perpendicular to the first sub-elements, and extend from the side of the first sub-elements as fingers. In this example, the second sub-elements 830a, 830b differ in terms of pitch and/or CD for the two sub-targets 810a, 810b. This provides the different best focus of the two sub-targets. As with Figure 7, this target is represented as it would print at different focus values along its length.

Figure 9 shows a fourth embodiment of a target (or main feature thereof), comprising a first sub-target 900a and second sub-target 900b. Each sub-target 900a, 900b comprises respective main feature elements 910a, 910b, each respective main feature element 910a, 910b comprising a respective first sub-element 920 and second sub-elements 930a, 930b. In this example, the target is symmetrical in the direction of periodicity around its center element which in this example, comprises only a first sub-element 920 (i.e., it has no significant focus dependency provided by the second sub-elements 930a, 930b). In contrast to Figures 7 and 8, the target is represented in Figure 9 as it may look on the mask, or as printed at a single focus level.

This target type provides a focus dependent change in main feature pitch, which may be measured in the same manner as has been described; e.g., via fringes imaged from first and second diffraction orders or Moire fringes where a reference feature is also provided.

In Figure 9, the target is shown as a symmetrical version of the target of Figure 8. However, the same concept may be applied to the main feature elements of the targets of Figure 7 or Figure 6(a) to obtain targets with focus dependent pitch.

Figure 10 illustrates a first Moire sub-target 1000 type suitable for providing a Moire signal, from which center-of-mass difference (or pitch difference using a symmetrical target) between two such sub-targets can be determined as has been described. An upper layer (or layer of interest for which a focus value is being determined) comprises a focus dependent sub-target main feature 1010. In a lower layer or reference layer and below the sub-target main feature 1010 is a further periodic reference feature 1020 (e.g., formed with no focus dependency). This reference feature 1020 has a reference pitch P_{ref} which is different to (but may be close to) main feature pitch Pₘₐᵢₙ. Interference of the (e.g., first) diffraction orders from these features 1010, 1020 will result in a Moire pattern on the detector, with focus dependent fringe position. In this example, the sub-target main feature 1010 is shown as sub-target 600a of Figure 6(a). However, this main feature 1010 may comprise any of the main feature sub-target arrangements illustrated and/or described herein. As before, the sub-targets can be paired with another sub-target having a different best focus obtained through Mask3D effects, and provides self-referencing for the fringe position.

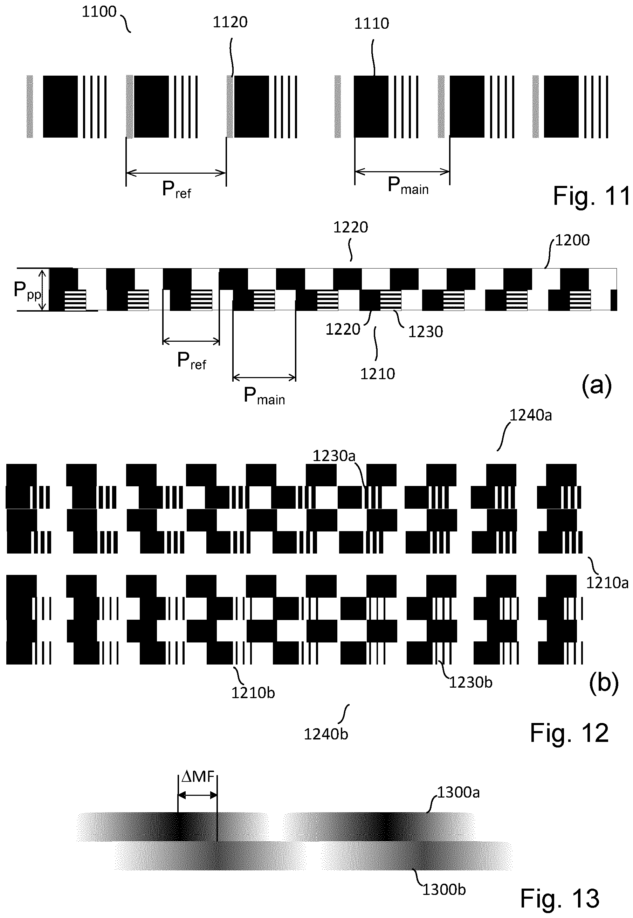

Figure 11 illustrates a second Moire sub-target 1100 type suitable for providing a Moire signal. In this example, the target is formed in a single layer (layer of interest) and comprises a sub-target main feature 1110 interlaced with the sub-target reference feature 1120 (e.g., formed with no focus dependency). Interlaced in this context means that the main feature elements alternate with the reference feature elements. Again the reference pitch P_{ref} is different to (and may be close to) the main feature pitch Pₘₐᵢₙ. As with the previous example, the sub-target main feature 1110 of this second Moire sub-target 1100 type may comprise any of the main feature sub-target arrangements illustrated and/or described herein and, as before, the sub-targets can be paired with another sub-target having a different best focus obtained through Mask3D effects.

Figure 12 illustrates a third Moire sub-target type suitable for providing a Moire signal. Again in this example, the target is formed in a single layer (layer of interest). However this arrangement is expected to provide improved performance over that illustrated in Figure 11. Figure 12(a) shows an exemplary unit cell of this quasi-interlaced arrangement, comprising main feature portion 1210 and reference feature portion 1220. Two or more of these unit cells are stacked such that the reference feature and main feature are interlaced (alternate) in a direction perpendicular to the periodicity of the main target pitch Pₘₐᵢₙ. Main feature again comprises a first sub-element 1220 and second sub-elements 1230. Figure 12(b) shows a target according to this concept, comprising first sub-target 1240a and second sub target 1240b. As before, the CD and/or pitch of sub-elements of the main feature element 1210a is different to the CD and/or pitch of sub-elements of the main feature element 1210b. Specifically, it is shown here that the second sub-elements 1230a have a different CD and/or pitch than second sub-elements 1230b, although it may be dimensions of the first sub-element which differ in this way depending on the actual design of the main feature. As before, the main feature may differ from that shown and may comprise any of the main features described herein (it can be noted for example, that the main feature 1210 in Figure 12(a) has a different design to the main feature 1210a, 1210b in Figure 12(b)).

The perpendicular pitch of the main feature in the perpendicular direction P_{PP} may be sufficiently small to be unresolved. For example this perpendicular pitch P_{PP} may meet the criterion *λ*/P_{PP}>1.2, where *λ* is the radiation wavelength of the measurement radiation.

Figure 13 is an example of the Moire images which may be captured from any of the Moire embodiments described herein. Shown is a first Moire image 1300a (e.g., obtained from a first sub-target) and second Moire image 1300b (e.g., obtained from a second sub-target). The positions of respective fringes (e.g., intensity maxima or minima) can be identified. A difference of these Moire fringes ΔMF will be indicative of (i.e., proportional to) the difference in center-of-mass of the sub-targets ΔCoM, and therefore can be calibrated against defocus as has been described. Once calibrated, the calibrated relationship can be used to translate the Moire fringe difference ΔMF to a focus value. In this way, a self-referenced measurement can be performed from the focus target.

Moire focus target are presently unknown, and therefore also disclosed herein is a focus target or sub-target thereof comprising at least a periodic main feature having a main feature pitch and wherein the center-of-mass and/or main feature pitch is focus dependent; and a periodic reference feature having a reference feature pitch different from said main feature pitch, the main feature and reference feature being arranged such that scattered radiation from the main feature and the reference feature interfere to form a beat signal or Moire signal.

In all the embodiments described, each target as described may be paired with a mirrored or 180degree rotated version of that target such that overlay content can be removed/separated from the focus inference. For the mirrored pair, any overlay content will cause a fringe shift in the same direction for the pair, while the focus shift will be in opposite directions, enabling their separation.

In association with the physical grating structures of the targets realized on substrates and patterning devices, an embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3 and/or the control unit LACU of Figure 2. There may also be provided a data storage medium (e.g., semiconductor memory, magnetic or optical disk) having such a computer program stored therein. Where an existing metrology apparatus, for example of the type shown in Figure 3, is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Therefore, disclosed is a target arrangement suitable for metrology of a lithographic process comprising at least two targets positioned within the target arrangement such that the target arrangement has a symmetry upon rotation. The at least two targets may be positioned within the target arrangement such that a measured property of the at least two target has a symmetry upon rotation. Also disclosed is a method to measure a parameter of a lithographic process comprising measuring at least two targets of a metrology target arrangement by illuminating the targets with radiation and detecting the radiation scattered by the targets and determining a property in the measurement of the targets wherein the property has a symmetry upon rotation.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Further embodiments according to the present invention are described in below numbered clauses:
1. A method of measuring a focus parameter from a focus target, the focus target comprising at least one self-referenced pair of sub-targets, the self-referenced pair of sub-targets comprising a first sub-target and a second sub-target, wherein each of said first sub-target and second sub-target comprises at least a periodic main feature; wherein a respective pitch and/or dimensional parameter of at least some sub-elements of the main feature are configured such that said first sub-target and second sub-target have a respective different best focus value; and wherein each said main feature is formed with a focus dependent center-of-mass and/or pitch; the method comprising: obtaining a first measurement signal from said first sub-target and a second measurement signal from said second sub-target; determining a difference signal of said first measurement signal and second measurement signal; and determining said focus parameter from said difference signal.
2. A method according to clause 1, wherein said first measurement signal and second measurement signal are phase signals, and the method comprises using each sub-target to reference the phase of the other sub-target.
3. A method according to clause 1 or 2, wherein a main feature pitch of the main feature and wavelength of measurement radiation is configured to provide at least a detectable first diffraction order from each sub-target.
4. A method according to clause 3, wherein a ratio of wavelength of the measurement radiation to said main feature pitch is between 0.7 and 1.3.
5. A method according to any preceding clause, comprising capturing at least one first diffraction order and at least one second diffraction order from measurement radiation scattered by each of said first sub-target and said second sub target; imaging interference fringes of interference between said at least one first diffraction order and at least one second diffraction order from the first sub-target to obtain said first measurement signal; and imaging interference fringes of interference between said at least one first diffraction order and at least one second diffraction order from the second sub-target to obtain said second measurement signal.
6. A method according to clause 5, wherein a main feature pitch of the main feature and wavelength of measurement radiation is configured to provide at least a detectable first diffraction order and second diffraction order from each sub-target.
7. A method according to any of clauses 1 to 4, wherein each sub-target comprises a periodic reference feature having a reference feature pitch which is different from a main feature pitch of the main feature, such that scattered radiation from the main feature and the reference feature interfere to form a Moire signal.
8. A method according to clause 7, wherein said main feature pitch and reference feature pitch differ by less than 20% of the main feature pitch.
9. A method according to clause 7 or 8, comprising imaging Moire fringes resulting from interference between at least one diffraction order from the main feature of said first sub-target and at least one corresponding diffraction order from the reference feature of said first sub-target to obtain said first measurement signal; and imaging Moire fringes resulting from interference between at least one diffraction order from the main feature of said first sub-target and at least one corresponding diffraction order from the reference feature of said second sub-target to obtain said second measurement signal.
10. A method according to clause 7, 8 or 9, wherein said reference feature of each sub-target is comprised in a layer below a layer of interest comprising said main feature of each sub-target.
11. A method according to clause 7, 8 or 9, wherein said reference feature of each sub-target and said main feature of each sub-target are both comprised within the same layer.
12. A method according to clause 11, wherein, for each sub-target, the main feature and reference feature are interlaced in a direction of periodicity of the main feature and reference feature, such that main feature elements of the main feature alternate with reference feature elements of the reference feature in said direction of periodicity.
13. A method according to clause 11, wherein, for each sub-target, the main feature and reference feature are interlaced in a direction perpendicular to the periodicity of the main feature and reference feature, such that main feature elements of the main feature alternate with reference feature elements of the reference feature in said direction perpendicular to the periodicity of the main feature and reference feature.
14. A method according to clause 13, wherein a perpendicular pitch of the main feature in said perpendicular direction below the resolution limit of the apparatus used to perform said measurement signals.
15. A method according to clause 13 or 14, wherein a ratio of wavelength of the measurement radiation to said perpendicular pitch is greater than 1.2.
16. A method according to any of clauses 5 to 15, wherein said difference signal comprises the difference in position of corresponding said fringes in said first measurement signal and second measurement signal.
17. A method according to any preceding clause, wherein each said main feature is formed with a focus dependent center-of-mass, said center-of-mass of each sub-target describing the peak position of a first harmonic of a pattern defined by the sub-target when printed.
18. A method according to any of clauses 1 to 16, wherein each said main feature is formed with a focus dependent pitch, said main feature being substantially symmetrical around an axis of symmetry parallel to the direction of periodicity of the main feature.
19. A method according to any preceding clause, wherein said main feature of each of the sub-target comprises a periodic array of main feature elements.
20. A method according to clause 19, wherein some or all of said main feature elements each comprise a larger first sub-element and multiple smaller second sub-elements.
21. A method according to clause 20, wherein said second sub-elements comprises features having a CD and/or pitch at or close to product dimensions.
22. A method according to clause 20 or 21, wherein said second sub-elements forms a periodic structure with periodicity in a direction parallel to the longest dimension of the first sub-element.
23. A method according to clause 20 or 21, wherein said second sub-elements forms a periodic structure with periodicity in a direction perpendicular to the longest dimension of the first sub-element.
24. A method according to any of clauses 20 to 23, wherein said at least some sub-elements of the main feature which are configured such that said first sub-target and second sub-target have a respective different best focus value comprise said second sub-elements.
25. A method according to any of clauses 20 to 24, wherein said first sub-elements each comprise a solid or single filled structure.
26. A method according to any of clauses 20 to 24, wherein said first sub-elements each comprise a periodic structure.
27. A method according to clause 26, wherein said at least some sub-elements of the main feature which are configured such that said first sub-target and second sub-target have a respective different best focus value comprise said first sub-elements.
28. A method according to any preceding clause, comprising obtaining a calibrated relationship between said difference signal and said focus parameter to determine said focus parameter from said difference signal.
29. A method according to any preceding clause, comprising an initial step of exposing said focus target on a substrate; and
   measuring said focus target to obtain said first measurement signal and second measurement signal.
30. A method according to clause 29, comprising using a scatterometer to measure said focus target in said measuring step.
31. A method according to any preceding clause, wherein said focus target is paired with a mirrored or 180degree rotated version of said focus target; and the method comprises removing overlay content from the determined focus parameter from measurement signals obtained from the paired focus targets.
32. A method according to any preceding clause, wherein said dimensional parameter is critical dimension.
33. A method according to any preceding clause, wherein said focus parameter describes a focus setting of a lithographic exposure process in which said focus target was exposed.
34. A substrate comprising at least one focus target for measuring a focus parameter, the focus target comprising at least one self-referenced pair of sub-targets, the self-referenced pair of sub-targets comprising a first sub-target and a second sub-target, wherein each of said first sub-target and second sub-target comprises at least a periodic main feature; wherein a respective pitch and/or dimensional parameter of at least some sub-elements of the main feature are configured such that said first sub-target and second sub-target have a respective different best focus value; and wherein each said main feature is formed with a focus dependent center-of-mass and/or pitch.
35. A substrate according to clause 34, wherein each sub-target comprises a periodic reference feature having a reference feature pitch which is different from a main feature pitch of the main feature, such that scattered radiation from the main feature and the reference feature interfere to form a Moire signal.
36. A substrate according to clause 35, wherein said main feature pitch and reference feature pitch differ by less than 20% of the main feature pitch.
37. A substrate according to clause 34, 35 or 36, wherein said reference feature of each sub-target is comprised in a layer below a layer of interest comprising said main feature of each sub-target.
38. A substrate according to clause 34, 35 or 36, wherein said reference feature of each sub-target and said main feature of each sub-target are both comprised within the same layer.
39. A substrate according to clause 38, wherein, for each sub-target, the main feature and reference feature are interlaced in a direction of periodicity of the main feature and reference feature, such that main feature elements of the main feature alternate with reference feature elements of the reference feature in said direction of periodicity.
40. A substrate according to clause 38, wherein, for each sub-target, the main feature and reference feature are interlaced in a direction perpendicular to the periodicity of the main feature and reference feature, such that main feature elements of the main feature alternate with reference feature elements of the reference feature in said direction perpendicular to the periodicity of the main feature and reference feature.
41. A substrate according to any of clauses 34 to 40, wherein each said main feature has been formed with a focus dependent center-of-mass, said center-of-mass of each sub-target describing the peak position of a first harmonic of a pattern defined by the sub-target when printed.
42. A substrate according to any of clauses 34 to 40, wherein each said main feature is formed with a focus dependent pitch, said main feature being substantially symmetrical around an axis of symmetry parallel to the direction of periodicity of the main feature.
43. A substrate according to any of clauses 34 to 42, wherein said main feature of each of the sub-target comprises a periodic array of main feature elements.
44. A substrate according to clause 43, wherein some or all of said main feature elements each comprise a larger first sub-element and multiple smaller second sub-elements.
45. A substrate according to clause 44, wherein said second sub-elements comprises features having a CD and/or pitch at or close to product dimensions.
46. A substrate according to clause 44 or 45, wherein said second sub-elements forms a periodic structure with periodicity in a direction parallel to the longest dimension of the first sub-element.
47. A substrate according to clause 44 or 45, wherein said second sub-elements forms a periodic structure with periodicity in a direction perpendicular to the longest dimension of the first sub-element.
48. A substrate according to any of clauses 44 to 47, wherein said at least some sub-elements of the main feature which are configured such that said first sub-target and second sub-target have a respective different best focus value comprise said second sub-elements.
49. A substrate according to any of clauses 44 to 48, wherein said first sub-elements each comprise a solid or single filled structure.
50. A substrate according to any of clauses 44 to 48, wherein said first sub-elements each comprise a periodic structure.
51. A substrate according to clause 50, wherein said at least some sub-elements of the main feature which are configured such that said first sub-target and second sub-target have a respective different best focus value comprise said first sub-elements.
52. A substrate according to any of clauses 34 to 51, wherein said focus target is paired on said substrate with a mirrored or 180degree rotated version of said focus target.
53. A substrate according to any of clauses 34 to 52, wherein said dimensional parameter is critical dimension.
54. A substrate according to any of clauses 34 to 53, wherein said focus parameter describes a focus setting of a lithographic exposure process in which said focus target was exposed.
55. A substrate comprising at least one focus target or sub-target thereof comprising at least a periodic main feature having a main feature pitch, wherein a center-of-mass and/or main feature pitch is focus dependent; and a periodic reference feature having a reference feature pitch different from said main feature pitch, the main feature and reference feature being arranged such that scattered radiation from the main feature and the reference feature interfere to form a beat signal or Moire signal.
56. A substrate according to clause 55, wherein said main feature pitch and reference feature pitch differ by less than 20% of the main feature pitch.
57. A substrate according to clause 55 or 56, wherein said reference feature is comprised in a layer below a layer of interest comprising said main feature of each sub-target.
58. A substrate according to clause 55 or 56, wherein said reference feature and said main feature are both comprised within the same layer.
59. A substrate according to clause 58, wherein the main feature and reference feature are interlaced in a direction of periodicity of the main feature and reference feature, such that main feature elements of the main feature alternate with reference feature elements of the reference feature in said direction of periodicity.
60. A substrate according to clause 58, wherein, for each sub-target, the main feature and reference feature are interlaced in a direction perpendicular to the periodicity of the main feature and reference feature, such that main feature elements of the main feature alternate with reference feature elements of the reference feature in said direction perpendicular to the periodicity of the main feature and reference feature.
61. A substrate according to any of clauses 55 to 60, wherein said main feature has been formed with a focus dependent center-of-mass, said center-of-mass of each sub-target describing the peak position of a first harmonic of a pattern defined focus target when printed.
62. A substrate according to any of clauses 55 to 60, wherein each said main feature is formed with a focus dependent pitch, said main feature being substantially symmetrical around an axis of symmetry parallel to the direction of periodicity of the main feature.
63. A substrate according to any of clauses 55 to 62, wherein said main feature comprises a periodic array of main feature elements.
64. A substrate according to clause 63, wherein some or all of said main feature elements each comprise a larger first sub-element and multiple smaller second sub-elements.
65. A substrate according to clause 64, wherein said second sub-elements comprises features having a CD and/or pitch at or close to product dimensions.
66. A substrate according to clause 64 or 65, wherein said second sub-elements forms a periodic structure with periodicity in a direction parallel to the longest dimension of the first sub-element.
67. A substrate according to clause 64 or 65, wherein said second sub-elements forms a periodic structure with periodicity in a direction perpendicular to the longest dimension of the first sub-element.
68. A substrate according to any of clauses 64 to 67, wherein said first sub-elements each comprise a solid or single filled structure.
69. A substrate according to any of clauses 64 to 67, wherein said first sub-elements each comprise a periodic structure.
70. A substrate according to any of clauses 55 to 69, wherein said focus target is paired on said substrate with a mirrored or 180degree rotated version of said focus target.
71. A substrate according to any of clauses 55 to 70, wherein said focus parameter describes a focus setting of a lithographic exposure process in which said focus target was exposed.
72. A patterning device comprising target patterning features for forming said focus target on said substrate to obtain the substrate of any of clauses 34 to 71.
73. A method of measuring a focus parameter from a focus target on a substrate according to any of clauses 55 to 72, comprising: imaging Moire fringes resulting from interference between at least one diffraction order from the main feature and at least one corresponding diffraction order from the reference feature to obtain a measurement signal; and determining said focus parameter from said measurement signal.
74. A computer program comprising program instructions operable to cause a metrology apparatus to perform the method of any of clauses 1 to 33, when run on a suitable apparatus.
75. A non-transient computer program carrier comprising the computer program of clause 74.
76. A processing arrangement comprising: the non-transient computer program carrier of clause 74; and a processor operable to run said computer program.
77. A metrology apparatus comprising the processing arrangement of clause 76.
78. A lithographic apparatus comprising: a patterning device support for supporting a patterning device; a substrate support for supporting a substrate; wherein the lithographic apparatus is operable to perform use the determined focus parameter value in correcting a further lithographic exposure.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), A well A particle beams, such A ion beams or electron beams.

The term "lens", where the context allows, may refer to any one or combination of various types of components, including refractive, reflective, magnetic, electromagnetic and electrostatic components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A substrate comprising at least one focus target or sub-target thereof comprising at least a periodic main feature having a main feature pitch, wherein a center-of-mass and/or main feature pitch is focus dependent; and a periodic reference feature having a reference feature pitch different from said main feature pitch, the main feature and reference feature being arranged such that scattered radiation from the main feature and the reference feature interfere to form a beat signal or Moire signal.

2. A substrate as claimed in claim 1, wherein said main feature pitch and reference feature pitch differ by less than 20% of the main feature pitch.

3. A substrate as claimed in claim 1 or 2, wherein said reference feature is comprised in a layer below a layer of interest comprising said main feature of each sub-target.

4. A substrate as claimed in claim 1 or 2, wherein said reference feature and said main feature are both comprised within the same layer.

5. A substrate as claimed in any of claims 1 to 4, wherein said main feature has been formed with a focus dependent center-of-mass, said center-of-mass of each sub-target describing the peak position of a first harmonic of a pattern defined focus target when printed.

6. A substrate as claimed in any of claims 1 to 4, wherein each said main feature is formed with a focus dependent pitch, said main feature being substantially symmetrical around an axis of symmetry parallel to the direction of periodicity of the main feature.

7. A substrate as claimed in any of claims 1 to 6, wherein said main feature comprises a periodic array of main feature elements.

8. A substrate as claimed in any of claims 1 to 7, wherein said focus target is paired on said substrate with a mirrored or 180degree rotated version of said focus target.

9. A substrate as claimed in any of claims 1 to 8, wherein said focus parameter describes a focus setting of a lithographic exposure process in which said focus target was exposed.

10. A patterning device comprising target patterning features for forming said focus target on said substrate to obtain the substrate of any of claims 1 to 9.

11. A method of measuring a focus parameter from a focus target on a substrate as claimed in any of claims 1 to 10, comprising:
imaging Moire fringes resulting from interference between at least one diffraction order from the main feature and at least one corresponding diffraction order from the reference feature to obtain a measurement signal; and
determining said focus parameter from said measurement signal.
